# EUROPEAN PATENT APPLICATION

(11) **EP 1 098 437 A2**
(43) Date of publication of application: **09.05.2001**
(21) Application number: 00302087.2
(22) Date of filing: 15.03.2000
(51) Int. Cl.: H03J 1/00

(54) **Channel selection method and channel selection apparatus**

(30) Priority: 15.03.1999 JP 6905699
(71) Applicant: Mitsumi Electric Co., Ltd., Chofu-shi, Tokyo (JP)
(72) Inventor: Sugawara, Takesh, Mitsuni Electric Co., Ltd., Atsugi-shi, Kanagawa (JP); Yamashita, Tetsuyai, Mitsuni Electric Co., Ltd., Atsugi-shi, Kanagawa (JP)
(74) Representative: Midgley, Jonathan Lee

(57) **Abstract**

A channel selecting method for selecting a channel of a desired input signal from a plurality of input signals of different transmission modes, having the steps of receiving an input signal from a plurality of input signals and detecting the transmission mode of the received signal (S20), comparing the transmission mode detected in the transmission mode detecting step with the transmission mode of a signal that should be received (S30), and selecting a channel based on the results of the comparison of transmission modes made in the transmission mode comparing step (S40, 50).

## Description

### BACKGROUND OF THE INVENTION

### 1. Field of the Invention

The present invention relates generally to a channel selection method and channel selection apparatus, and more particularly, to a channel selection method and channel selection apparatus for selecting a desired input signal from a plurality of input signals of different transmission modes.

### 2. Description of the Related Art

The increasing popularity of the compact disk, or CD, has accustomed consumers to the superior quality and ease of use of digital audio recordings, with the result that digitized audio broadcasting is becoming increasingly common. Such digital audio broadcasting, or DAB, can provide listeners with high value-added services using either satellite or ground-based radio wave transmissions.

DAB utilizes four different transmission modes, each defined according to the characteristics of the transmission. For example, Mode I has a working frequency of 375 MHz or lower, and is especially suited for single-frequency networks. Mode II has a working frequency of 1.5 GHz or lower and is especially suited for ground-based transmissions. Mode III has a working frequency of 3.0 GHz or lower and is especially suited for satellite transmissions.

A description will now be given with reference to the accompanying drawings of a channel selection apparatus for selecting a channel of a signal in the so-called band III range within the Mode I working frequency, that is, a signal having a frequency of 174-240 MHz, and a channel of a signal in the so-called L band range within the Mode II working frequency, that is, a signal having a frequency of 1452-1492 MHz.

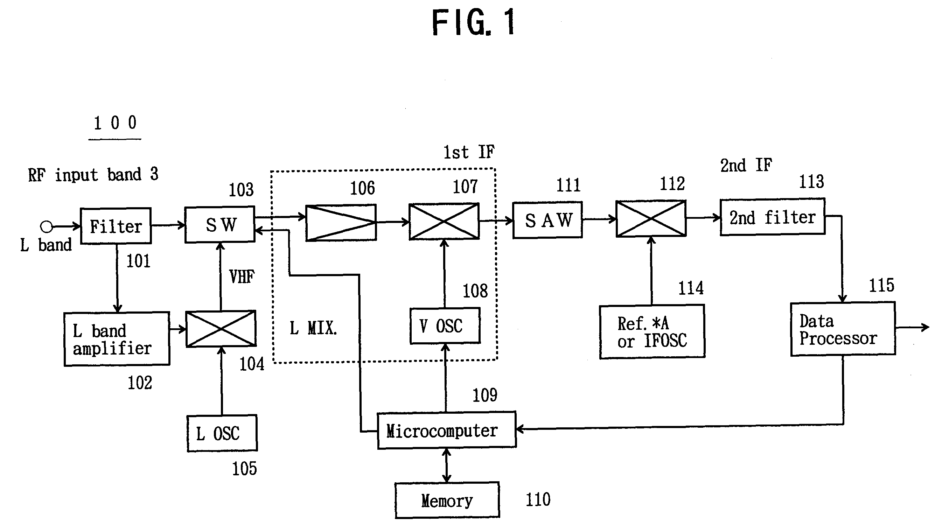

FIG. 1 is a block diagram of a conventional reception circuit including a channel selection apparatus. When the reception circuit 100 is supplied with a band III signal and an L band signal, the band III signal and the L band signal are supplied to a filter unit 101. The filter unit 101 comprises for example a low pass filter, or LPF, and a high pass filter, or HPF, the LPF and the HPF each being supplied with the band III signal and the L band signal.

Of the band III signal and the L band signal, the LPF supplies a switch (SW) 103 with only the L band signal. Of the band III signal and the L band signal, the HPF supplies an L band signal amplifier 102 with only the L band signal.

The L band signal amplifier 102 amplifies the supplied L band signal and supplies the amplified signal to a mixer 104. The mixer 104 down-converts the L band signal supplied from the L band signal amplifier 102 to the band III frequency band based on a signal supplied from a local oscillator 105 and supplies the down-converted signal to the switch 103.

The switch 103 selects either the band III signal supplied from the filter unit 101 or the down-converted L band signal supplied from the mixer 104 and outputs the selected signal to an amplifier 106. The switch 103 is controlled by a microcomputer (microprocessor) 109 to be described later so that the selected signal is output. It should be noted that the switch 103 comprises a gallium-arsenide field effect transistor, or FET.

The amplifier 106 amplifies the supplied signal and supplies that amplified signal to another mixer 107. The mixer 107 down-converts the signal supplied from the amplifier 106 to a first intermediate frequency based on a signal supplied from another local oscillator 108 and supplies the down-converted signal to a surface acoustic wave, or SAW, filter 111. It should be noted that the microcomputer 109 controls the local oscillator 108 so as to control the frequency of the signal supplied to the mixer 107.

The SAW filter 111 is utilized in order to maintain the orthogonality of the carrier. The SAW filter 111 supplies the supplied signal to a third mixer 112. The mixer 112 down-converts the signal supplied from the SAW filter 111 to a second intermediate frequency based on a signal supplied from a third local oscillator 114 and supplies the down-converted signal to a data processor 115 via another filter 113.

When the data processor 115 receives a signal supplied from the filter 113, the data processor 115 supplies a signal indicating the presence of a signal to the microcomputer 109. The microcomputer 109 then stores the input frequency at the time the signal indicating the presence of a signal is supplied in a memory device 110. The microcomputer 109 then continues to change the frequencies of the signals supplied by the local oscillator 108 in sequence, and by repeating the above-described processes performs channel selection.

However, in the case of the conventional channel selection apparatus, when selecting a channel by selecting a down-converted L-band signal supplied from the mixer 104 using the switch 103, if the isolation of the switch 103 is inadequate the band III signal interferes with proper channel selection.

The reason is that, when the isolation of the switch 103 is inadequate, a band III signal is included in the down-converted L band signal output from the switch 103, and this band III signal is mistaken for an L band signal.

On the other hand, to fully obtain isolation requires a complicated circuit structure, which increases production costs.

### SUMMARY OF THE INVENTION

Accordingly, it is a general object of the present invention to provide an improved and useful channel selection method and channel selection apparatus, in which the disadvantages described above are eliminated.

Another and more specific object of the present invention is to provide an improved and useful channel selection method and channel selection apparatus in which channel selection of input signals of different transmission modes can be performed correctly even if isolation of the switch is less than adequate.

The above-described objects of the present invention are achieved by a channel selecting method for selecting a channel of a desired input signal from a plurality of input signals of different transmission modes, characterized by having the steps of:
(a) receiving an input signal from a plurality of input signals and detecting the transmission mode of the received signal;
(b) comparing the transmission mode detected in the transmission mode detecting step (a) with the transmission mode of a signal that should be received; and
(c) selecting a channel based on the results of the comparison of transmission modes made in the transmission mode comparing step (b).

According to the invention described above, channel selection of input signals of different transmission modes can be performed correctly even if isolation is inadequate. Accordingly, the complicated circuit structure required for adequate isolation is unnecessary and production costs can be reduced.

Additionally, the above-described objects of the present invention are also achieved by the channel selecting method as described above, characterized in that the method determines that a correct signal has been selected when the comparison made in the transmission mode comparing step (b) indicates that the transmission mode detected in the transmission mode detecting step (a) matches the transmission mode of the signal that should be received and stores channel selection data for selecting the correct signal, and determines that an incorrect signal has been selected when the comparison made in the transmission mode comparing step (b) indicates that the transmission mode detected in the transmission mode detecting step (a) does not match the transmission mode of the signal that should be received and does not store channel selection data for selecting the incorrect signal.

According to the invention described above, channel selection can be performed correctly.

The above-described objects of the present invention are also achieved by a channel selecting apparatus selecting a channel of a desired input signal from a plurality of input signals of different transmission modes, characterized by having:
transmission mode detecting means for receiving the desired input signal from a plurality of input signals and detecting a transmission mode of the received signal;
transmission mode comparing means for comparing the transmission mode detected by the transmission mode detecting means with the transmission mode of a signal that should be received; and
channel selecting means for selecting a channel based on the results of the comparison made by the transmission mode comparing means.

According to the invention described above, channel selection of input signals of different transmission modes can be performed correctly even if isolation is inadequate. Accordingly, the complicated circuit structure required for adequate isolation is unnecessary and production costs can be reduced.

The above-described objects of the present invention are also achieved by the channel selecting apparatus as described above, further characterized by having:
determining means for determining whether or not the transmission mode detected by the transmission mode detecting means matches the transmission mode of the signal that should be received;
data storing means for storing channel selection data for selecting the desired input signal; and
control means for determining that a correct signal has been selected when the comparison made by the transmission mode comparing means indicates that the transmission mode detected by the transmission mode detecting means matches the transmission mode of the signal that should be received and storing channel selection data for selecting the correct signal, and determining that an incorrect signal has been selected when the comparison made by the transmission mode comparing means indicates that the transmission mode detected by the transmission mode detecting means does not match the transmission mode of the signal that should be received and not storing channel selection data for selecting the incorrect signal.

According to the invention described above, channel selection can be performed correctly even if input signals other than the desired input signal are present. Accordingly, the complicated circuit structure required for adequate isolation is unnecessary and production costs can be reduced.

Other objects, features and advantages of the present invention will become more apparent from the following detailed description when read in conjunction with the accompanying drawings.

### BRIEF DESCRIPTION OF THE DRAWINGS

FIG. 1 is a block diagram of a conventional reception circuit including a channel selection apparatus;
FIG. 2 is a block diagram of a receiver circuit including a channel selection apparatus according to one embodiment of the present invention;
FIG. 3 is a flow chart of steps performed by a channel selection apparatus according to one embodiment of the present invention; and
FIG. 4 is a structural diagram of a DAB receiver.

### DESCRIPTION OF THE PREFERRED EMBODIMENTS

A description will now be given of an embodiment of a voltage-current conversion circuit according to the present invention, with reference to the accompanying drawings.

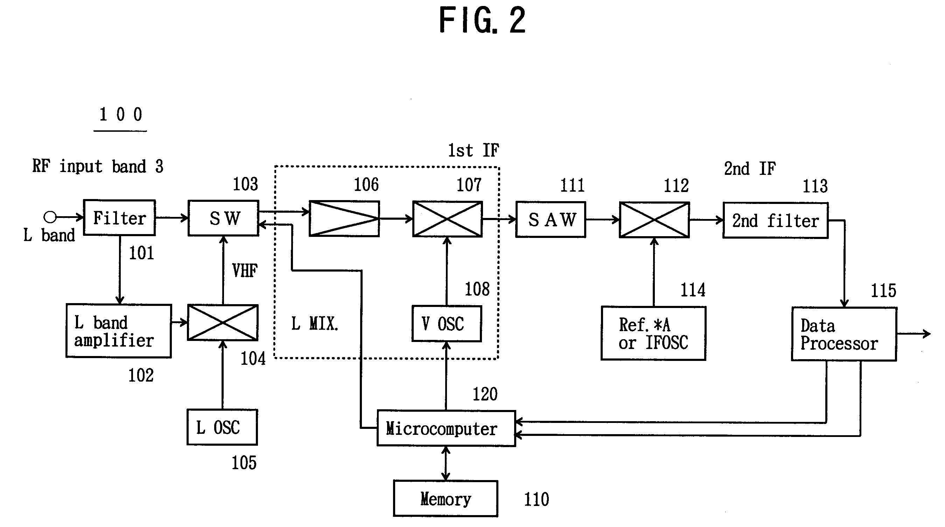

FIG. 2 is a block diagram of a receiver circuit including a channel selection apparatus according to one embodiment of the present invention.

As shown in the diagram, the receiver circuit 100 comprises a filter unit 101, an L band signal amplifier 102, a switch SW 103, mixers 104, 107, 112, local oscillators 105, 108, 114, amplifier 106, memory unit 110, SAW filter 111, filter 113, data processor 115 and microcomputer 120.

For the purpose of explaining the operation of the channel selection apparatus of the present invention a description will be given, with reference to the accompanying diagrams, of a channel selection of a band III 174-240 MHz signal within the Mode I working frequency and of an L band 1452-1492 MHz signal within the Mode II working frequency.

When the receiving circuit 100 is supplied with a band III signal and an L band signal, the band III and L band signals are supplied to a filter unit 101. The filter unit 101 may for example comprise a low pass filter, or LPF, and a high pass filter, or HPF, the LPF and the HPF each being supplied with the band III signal and the L band signal.

Of the band III signal and the L band signal, the LPF supplies a switch (SW) 103 with only the L band signal. Of the band III signal and the L band signal, the HPF supplies an L band signal amplifier 102 with only the L band signal.

The L band signal amplifier 102 amplifies the supplied L band signal and supplies the amplified signal to the mixer 104. The mixer 104 down-converts the L band signal supplied from the L band signal amplifier 102 to the band III frequency band based on a signal supplied from the local oscillator 105 and supplies the down-converted signal to the switch 103.

The switch 103 selects either the band III signal supplied from the filter unit 101 or the down-converted L band signal supplied from the mixer 104 and outputs the selected signal to the amplifier 106. The switch 103 is controlled by the microcomputer 120 to be described later so that the selected signal is output. It should be noted that the switch 103 comprises a gallium-arsenide field effect transistor, or FET.

When selecting a band III signal channel, for example, the switch 103 outputs the band III signal to the amplifier 106, and when selecting an L band signal channel, the switch outputs the down-converted L band signal to the amplifier 106. It should be noted that, in the present invention, it is not necessary that the switch 103 isolation be complete, a level of for example approximately 80 dB being sufficient.

The amplifier 106 amplifies the supplied signal and supplies the amplified signal to the mixer 107. The mixer 107 down-converts the signal supplied from the amplifier 106 to a first intermediate frequency based on a signal supplied from the local oscillator 108 and supplies the down-converted signal to the SAW filter 111. It should be noted that local oscillator 108 is controlled by the microcomputer 120 so as to control the frequency of the signal supplied to the mixer 107.

The SAW filter 111 is utilized in order to maintain the orthogonality of the carrier. The SAW filter 111 supplies the supplied signal to the mixer 112. The mixer 112 down-converts the signal supplied from the SAW filter 111 to a second intermediate frequency based on a signal supplied from the local oscillator 114 and supplies the down-converted signal to a data processor 115 via another filter 113.

When the data processor 115 receives a signal supplied from the filter 113, the data processor 115 identifies the transmission mode of the signal and supplies a mode detection signal indicating the transmission mode to the microcomputer 120. The microcomputer 120, when supplied with a mode detection signal indicating the transmission mode, determines whether or not to store the input frequency in the memory unit 110 based on the signal of the channel currently selected and the mode detection signal.

The processes performed by the microcomputer 120 utilize the fact that DAB signals are transmitted using different transmission modes, such as band III signals for mode I and L band signals for mode II or mode IV. The microcomputer 120 compares the transmission mode used to transmit the signal of the channel being selected with the transmission mode indicated by the mode detection signal supplied from the data processor and, if the two transmission modes do not match, determines that the signal is not the signal of the channel being selected and does not store the signal is the memory unit 110.

When selecting an L band signal channel, for example, if the isolation of the switch 103 is inadequate, then the band III signal is not completely eliminated but is selected together with the L band signal. However, the transmission modes of the band III signal and the L band signal are different, and when a mode detection signal indicating mode I is supplied from the data processor 115, the microcomputer 120 determines that the signal is not the L band signal of the channel being sought and does not store the signal in the memory unit 110.

By contrast, when supplied with a mode detection signal indicating mode II or mode IV, the microcomputer 120 determines that the signal is the L band signal of the channel being selected and stores the signal in the memory unit 110.

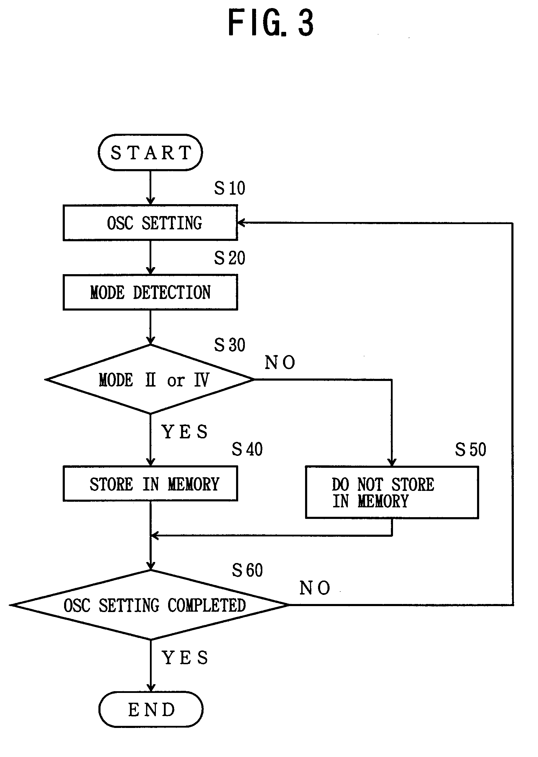

FIG. 3 is a flow chart of the above-described processes performed by the microcomputer 120 of the channel selection apparatus according to an embodiment of the present invention.

In a step S10, the microcomputer 120 controls the local oscillator 108 so as to cause the local oscillator 108 to output a signal necessary to perform channel selection. The signal is supplied to the mixer 107, the mixer down-converts the signal supplied from the amplifier 106 and supplies the down-converted signal to the SAW filter 111, the mixer 112 and the filter 113 via the data processor 115.

In a step S20, the data processor 115 detects the transmission mode of the supplied signal and supplies to the microcomputer 120 a mode detection signal based on the results of the detection. The process then proceeds to a step S30, in which the microcomputer 120 determines from the supplied mode detection signal whether or not the transmission mode of the signal of the channel being selected is mode II or mode IV.

If the transmission mode of the signal of the channel being selected is mode II or mode IV, that is, if it is determined that the signal is an L band signal (YES in step S30), then in a step S40 the frequency of the signal of the channel being selected is stored in the memory unit 110. On the other hand, if the transmission mode of the signal of the channel being selected is mode I, that is, if it is determined that the signal is a band III signal (NO in step S30), then in a step S50 the signal of the channel being selected is not necessary to the L band channel selection and so is not stored in the memory unit 110.

In a step S60, it is determined whether or not the channel selection of the L band signal is completed and, if channel selection is completed (YES in step S60), then the process terminates. On the other hand, if it is determined that channel selection of the L band signal is not completed (NO in step S60), then the process returns to step S10, with the microcomputer 120 controlling the local oscillator 108 so as to cause the local oscillator 108 to output a signal necessary to perform channel selection. Thereafter steps S10 through S60 are repeated until the process terminates.

As described above, the channel selection apparatus of the present invention compares the transmission mode of the signal of the channel being selected with the transmission mode indicated by the mode detection signal and determines that the signal is an incorrect signal in the event that the two transmission modes do not match. As a result, channel selection can be performed correctly even if isolation of the switch 103 is inadequate.

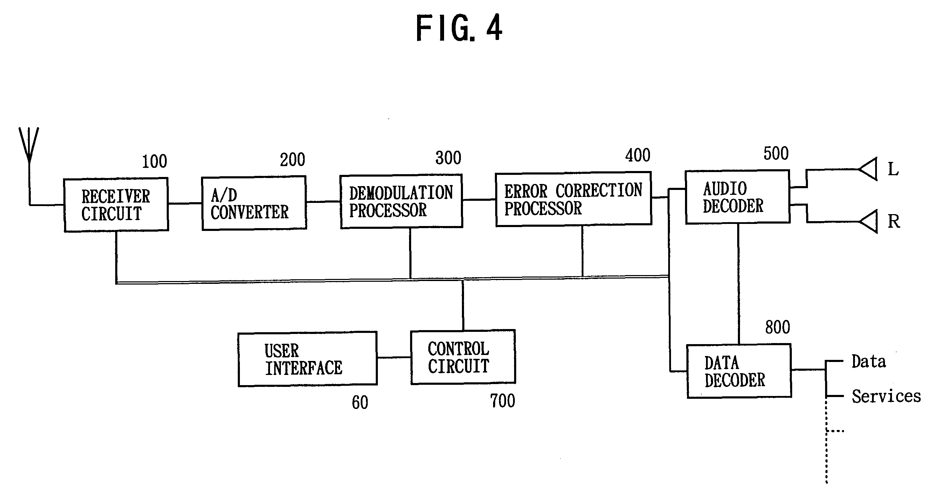

It should be noted that the receiver circuit 100 described above with reference to FIG. 2 forms part of a DAB receiver like that for example shown in FIG. 4. FIG. 4 is a structural diagram of a DAB receiver. As shown in the diagram, the DAB receiver comprises the receiver circuit 100, an A/D converter 200, a demodulator 300, an error correction processor 400, an audio decoder 500, a user interface 600, a control circuit 700 and a data decoder 800.

The receiver circuit 100 is supplied with RF signals of different frequencies depending on the transmission mode, the RF signal being converted into an IF signal and further converted into a 2^{nd} IF signal.

The converted 2^{nd} IF signal is supplied to the A/D converter 200 and converted from an analog signal into a digital signal. The converted digital signal is then supplied to the demodulator 300 and fast Fourier transform, or FFT, and differential modulation processing are performed.

The error correction processor 400 performs deinterleaving and error correction processing, and supplies the processed signal to the audio decoder 500 and the data decoder 800. The audio decoder 500 decompresses the supplied compressed audio data and outputs audio data.
The data decoder 800 demodulates and outputs informational data included in the audio data such as, for example, the name of the recording artist. Further, the user interface 600 enables a user to perform a variety of operations, on the basis of which the control circuit 700 controls the individual blocks.

It should be noted that although the present embodiment is described in terms of a receiver circuit receiving a 174-240 MHz band III signal within the mode I working frequency and a 1452-1492 MHz L band signal within the mode III working frequency, the present invention is not limited to such an embodiment but can be adapted for use with other transmission modes as well.

The above description is provided in order to enable any person skilled in the art to make and use the invention and sets forth the best mode contemplated by the inventors of carrying out the invention.

The present invention is not limited to the specifically disclosed embodiments and variations, and modifications may be made without departing from the scope and spirit of the present invention.

The present application is based on Japanese Priority Application No. 11-069056, filed on March 15, 1999, the entire contents of which are hereby incorporated by reference.

## Claims

1. A channel selecting method for selecting a channel of a desired input signal from a plurality of input signals of different transmission modes, characterized by having the steps of:
(a) receiving an input signal from a plurality of input signals and detecting the transmission mode of the received signal (S20);
(b) comparing the transmission mode detected in the transmission mode detecting step (a) with the transmission mode of a signal that should be received (S30); and
(c) selecting a channel based on the results of the comparison of transmission modes made in the transmission mode comparing step (b) (S40, 50).

2. The channel selecting method as claimed in claim 1, characterized in that the method determines that a correct signal has been selected when the comparison made in the transmission mode comparing step (b) indicates that the transmission mode detected in the transmission mode detecting step (a) matches the transmission mode of the signal that should be received and stores channel selection data for selecting the correct signal, and determines that an incorrect signal has been selected when the comparison made in the transmission mode comparing step (b) indicates that the transmission mode detected in the transmission mode detecting step (a) does not match the transmission mode of the signal that should be received and does not store channel selection data for selecting the incorrect signal.

3. A channel selecting apparatus (100) selecting a channel of a desired input signal from a plurality of input signals of different transmission modes, characterized by having:
transmission mode detecting means (115) for receiving an input signal from a plurality of input signals and detecting a transmission mode of the received signal;
transmission mode comparing means (120) for comparing the transmission mode detected by the transmission mode detecting means with the transmission mode of a signal that should be received; and
channel selecting means (110, 120) for selecting a channel based on the results of the comparison made by the transmission mode comparing means.

4. The channel selecting apparatus as claimed in claim 3, further characterized by having:
determining means (120) for determining whether or not the transmission mode detected by the transmission mode detecting means matches the transmission mode of the signal that should be received;
data storing means (110) for storing channel selection data for selecting the desired input signal; and
control means (120) for determining that a correct signal has been selected when the comparison made by the transmission mode comparing means indicates that the transmission mode detected by the transmission mode detecting means matches the transmission mode of the signal that should be received and storing channel selection data for selecting the correct signal, and determining that an incorrect signal has been selected when the comparison made by the transmission mode comparing means indicates that the transmission mode detected by the transmission mode detecting means does not match the transmission mode of the signal that should be received and not storing channel selection data for selecting the incorrect signal.
